# EUROPEAN PATENT SPECIFICATION

(11) **EP 4 235 814 B1**
(45) Date of publication and mention of the grant of the patent: **12.02.2025**
(21) Application number: 23158657.9
(22) Date of filing: 27.02.2023
(51) Int. Cl.: H01L 31/048, H01L 31/054, H01L 31/05

(54) **SOLAR CELL MODULE AND MANUFACTURING METHOD THEREOF**
SOLARZELLENMODUL UND HERSTELLUNGSVERFAHREN DAFÜR
MODULE DE CELLULE SOLAIRE ET SON PROCÉDÉ DE FABRICATION

(30) Priority: 25.02.2022 CN 202210177254
(43) Date of publication of application: 30.08.2023
(73) Proprietor: Ja Solar Technology Yangzhou Co., Ltd., Yangzhou City, Jiangsu Province 225009 (CN)
(72) Inventor: CHEN, Hongyue, Yangzhou City, Jiangsu Province 225009 (CN); ZHOU, Yanfang, Yangzhou City, Jiangsu Province 225009 (CN); NIU, Xinwei, Yangzhou City, Jiangsu Province 225009 (CN)
(74) Representative: Sun, Yiming

(56) References cited:
- WO-A1-2012/114638
- WO-A1-2021/203984
- JP-A- 2014 157 846
- JP-A- S5 660 071
- US-B2- 8 785 764

## Description

### TECHNICAL FIELD

Embodiments of the present invention relate to a manufacturing method of a solar cell module.

### BACKGROUND

With continuous development of the industry, a manufacturing ability of crystalline silicon has been constantly improved, and various large-sized silicon wafers have been used in the photovoltaic industry. At the same time, a research on high-efficiency solar cell is also making continuous progress. At present, a market share of a large-sized multi-busbar solar cell is getting higher and higher, and the large-sized multi-busbar solar cell has advantages of high efficiency and low cost. Currently, welding strips commonly used for a solar cell are a circular welding strip, a flat welding strip, etc. For the solar cell, it is necessary to reduce shading by a metal welding strip and reduce a distance between a back plate material and a solar cell, thereby improving a light extraction efficiency. WO 2012/114638 A1 describes a solar cell module having a laminated glass structure in which a solar cell element is interposed between a light receiving surface glass and a back surface glass. JP 2014 157846 A describes a photovoltaic device, an optical path changing member provided on at least a part of the periphery of the photovoltaic device to change an optical path of incident light, and disposed so as to cover the photovoltaic device and the optical path changing member. JP S56 60071 A describes a manufacturing method for a solar battery panel. US 8 785 764 B2 describes a photoelectric conversion device with an electrolyte inlet having a high sealing performance. WO 2021/203984 A1 describes a photovoltaic module.

### SUMMARY

The present invention is defined by the independent claim. Advantageous embodiments are described in the dependent claims, the following description and the drawings. An embodiment of the present invention provides a manufacturing method of a solar cell, which can reduce a total amount of the encapsulant material used, reduce a thickness of the encapsulant material layer, and reduce a distance between the back plate material and the solar cell string and/or the distance between the front plate material and the solar cell string, it also can avoid a charged body (e.g., the welding strip) being in direct contact with the glass, and improve anti-Potential Induced Degradation (PID) performance of the module.

In a first aspect, the manufacturing method of a solar cell module is provided, the method inter alia includes: providing a solar cell string; fabricating a back plate, a reserved hole being opened in the back plate; providing a front plate; arranging the solar cell string on the front plate; injecting an encapsulant material; and curing the encapsulant material, to obtain the solar cell module.

In a second aspect not falling under the scope of protection, a solar cell module is provided, which is manufactured by using the manufacturing method according to the first aspect.

### BRIEF DESCRIPTION OF THE DRAWINGS

In order to clearly illustrate the technical solution of the embodiments of the invention, the drawings of the embodiments will be briefly described in the following; it is obvious that the described drawings are only related to some embodiments of the invention and thus are not limitative of the invention.
FIG. 1 is a flow chart of an exemplary manufacturing method of a solar cell module of an embodiment of the present disclosure;
FIG. 2a is an exemplary plan view of a back plate;
FIG. 2b is a cross-sectional view of the back plate taken along line A-A' in FIG. 2a;
FIG. 3a is an exemplary plan view of a front plate;
FIG. 3b is a cross-sectional view of the front plate taken along line B-B' in FIG. 3a;
FIG. 4 is a schematic diagram of a solar cell string arranged between the front plate and the back plate;
FIG. 5 is a schematic diagram of a solar cell string arranged between a front plate glass and the back plate;
FIG. 6 is a schematic diagram of a solar cell string arranged between the front plate and the back plate; and
FIG. 7 is an exemplary schematic diagram of a solar cell module.

### DETAILED DESCRIPTION

In order to make objects, technical details and advantages of the embodiments of the invention apparent, the technical solutions of the embodiment will be described in a clearly and fully understandable way in connection with the drawings related to the embodiments of the invention. It is obvious that the described embodiments are just a part but not all of the embodiments of the invention.

Unless otherwise defined, all the technical and scientific terms used herein have the same meanings as commonly understood by one of ordinary skill in the art to which the present disclosure belongs. The terms, such as "first," "second," or the like, which are used in the description and the claims of the present disclosure, are not intended to indicate any sequence, amount or importance, but for distinguishing various components. The terms, such as "comprise/comprising," "include/including," or the like are intended to specify that the elements or the objects stated before these terms encompass the elements or the objects and equivalents thereof listed after these terms, but not preclude other elements or objects. The terms, such as "connect/connecting/connected," "couple/coupling/coupled" or the like, are not limited to a physical connection or mechanical connection, but may include an electrical connection/coupling, directly or indirectly. The terms, "on," "under," "left," "right," or the like are only used to indicate relative position relationship, and when the position of the object which is described is changed, the relative position relationship may be changed accordingly.

In a solar cell, a structure of a circular welding strip can reduce shading of a metal welding strip, and can reflect incident light from various angles, so currently mainstream multi-busbar modules on the market all use the circular welding strip. A thickness of a flat welding strip is usually 0.125 mm. When the welding strips have a same cross-sectional area, a diameter of the corresponding circular welding strip is also about 0.35 mm (originally, the diameter of the circular welding strip is 0.4 mm), which is 3 times a diameter of the flat welding strip. In order to ensure a yield of the module in a lamination process and reliability in a later time, an encapsulant film required by the module is also thicker than that of a conventional module, its thickness is usually more than 2 times that of the conventional module, and its weight is more than 1.5 times that of the conventional module. Moreover, even if the encapsulant film is thick, due to the large diameter of the circular welding strip and influence of the lamination process, it cannot be ensured that the circular welding strip can be protected by the encapsulant material and there will be a larger gap between the back plate material and the solar cell.

The closer the back plate material (such as a glass back plate) to the solar cell, the stronger a reflection effect on the light passing through the solar cell; and the larger a distance between the solar cell and the back plate material, the lower the power of the module.

In addition, as the large-sized battery is applied more widely, a size of the module also increases, so an amount of encapsulant material used and a weight of the module also increase, a cost of the module also increases, and difficulty in transportation and installation of the module increases as well. How to ensure the reliability of the module while reducing the weight of the module is a key research issue in the entire industry after the large-sized battery is widely applied.

At present, the following two schemes are adopted in the industry:

### 1. Reducing the diameter of the circular welding strip

Existing problems: a. At present, the diameter of the circular welding strip can be as small as 0.2 mm temporarily. However, due to reduction of the diameter of the welding strip, if the battery is not changed, a power loss of the module will increase and power will be sacrificed; if it is optimized, the battery needs to be changed, increasing the number of busbars, and increasing a silver paste consumption of the battery and the amount of welding strips used; b. After the welding strip becomes thinner, a yield strength of the welding strip becomes smaller, so it is easy to break during the manufacturing process; the welding strip is soft, and is difficult to stretch, and the welding strip will be bent, so that a precision of series welding becomes worse, the welding is difficult, and a defective rate increases;

2. Using a segmented welding strip. A front surface of the module uses a circular or triangular welding strip, to ensure full use of light, and a back surface thereof uses a flat welding strip. Existing problems: a. The power of the back surface is sacrificed by about 3%; b. It is hard to prepare the segmented welding strip, and because a residual stress at an interface of segments is relatively large, the segmented welding strip is relatively easy to break; in addition, a pattern thereof needs to be fixed, and a length of the segmented welding strip is not easy to change once fixed; c. During a welding process, devices need to be modified to identify the welding strip, and it is also necessary to avoid twisting of the welding strip, which will increase the defective rate of the process.

Therefore, it is necessary to reduce a thickness of an encapsulant material layer, for example, a thickness of the encapsulant material layer on the back surface, reduce an amount of the encapsulant material used, and reduce a distance between the back plate material and the solar cell, without reducing a diameter of a currently used circular welding strip while ensuring a sufficient yield strength of the welding strip and a small battery power loss; moreover, it also can avoid a charged body (e.g., the welding strip) being in direct contact with the glass, reduce influence of sodium ions, and improve anti-Potential Induced Degradation (PID) performance of the module.

Embodiments of the present disclosure provide a solar cell module and a manufacturing method thereof. The manufacturing method includes: providing a solar cell string; fabricating a back plate, wherein a reserved hole is opened in the back plate; providing a front plate; arranging the solar cell string on the front plate; injecting an encapsulant material; and curing the encapsulant material, to obtain the solar cell module. In this way, the encapsulant material is injected through an injection hole or is directly injected, and the encapsulant material is directly cured without a lamination process. Since no lamination process is performed, pressure exerted by the lamination process on the solar cell string is avoided, thereby preventing the solar cell string from defects such as hidden cracks and fractures caused by pressure, and avoiding breakage of the welding strip due to pressure, etc. Further, since fluidity of the liquid encapsulant material is very good, the gap can be well filled, thereby reducing the amount of the encapsulant material used, reducing the thickness of the encapsulant material layer, and reducing the distance between the back plate material and the cell string. Further, the front plate and the back plate are bonded by a glass glaze, and the glass glaze can ensure a gap between the front plate and the solar cell string and a gap between the back plate and the solar cell string, so that the welding strip cannot directly contact the front plate material and the back plate material. In this way, the glass glaze acts as a supporting frame between the front plate, the back plate and the solar cell string, and the encapsulant material is filled in the gaps supported by these frames, so as to ensure that the welding strip is well protected, and ensure that a flexible encapsulant material is filled between the welding strip and the back plate material (especially a glass back plate) to fully protect the welding strip, improve a yield of the solar cell and avoid defects such as breakage of the welding strip of the solar cell and damage to the solar cell. Moreover, the support of the glass glaze prevents a charged body (such as a welding strip, a solar cell, etc.) from directly contacting the glass, reduces the influence of sodium ions, and improves the anti-PID performance of the module. In this way, without reducing the diameter of the currently used circular welding strip while ensuring the sufficient yield strength of the welding strip and the small battery power loss, the distance between the back plate material and the solar cell is reduced, that is, the thickness of the encapsulant film on the back surface is reduced; and it can be ensured that the encapsulant film in the solar cell module can wrap the back surface of the welding strip away from the solar cell, that is, the surface facing the back plate material, so as to fully protect the welding strip.

Moreover, for the other welding strips other than the circular welding strip, as well as the busbars, by using no lamination process or the lamination process with small pressure in the present disclosure, an amount of the encapsulant material used can be reduced, a distance between the back plate material and the solar cell string can be reduced, a bonding strength of the back plate material to the solar cell string and the front plate material can be improved, the welding strip is fully protected and stability and performance of the solar cell module are improved.

Hereinafter, the manufacturing method of the solar cell module according to the embodiments of the present invention will be exemplarily described with reference to the accompanying drawings.

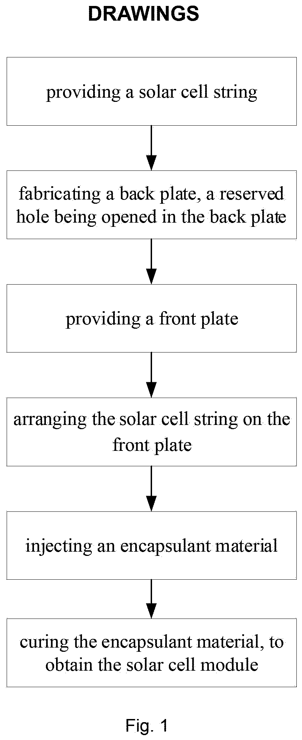

FIG. 1 shows an exemplary flow chart of a manufacturing method of a solar cell module according to an embodiment of the present disclosure. As shown in FIG. 1, the manufacturing method of a solar cell module includes: providing a solar cell string; fabricating a back plate, wherein a reserved hole is opened in the back plate; providing a front plate; arranging the solar cell string on the front plate; injecting an encapsulant material; and curing the encapsulant material, to obtain the solar cell module.

For example, in an embodiment of the present disclosure, the providing a solar cell string may include: connecting a plurality of solar cells; welding a plurality of welding strips on at least one surface of the plurality of solar cells, to form the solar cell string; and detecting the solar cell string connected with the plurality of welding strips, wherein, the solar cell string includes a lead.

For example, the detection may be an electroluminescence (EL) detection.

For example, the solar cell string may include one string of solar cells or more strings of solar cells, that is, the solar cells are formed in a plurality of rows and columns, solar cells in each row are connected to each other to form one string of solar cells, and solar cells in different strings are also connected by welding strips or busbars to form the solar cell string.

For example, a plurality of welding strips may be arranged on a front surface of the plurality of solar cells, and the plurality of welding strips are welded on the front surface of the solar cells, or a plurality of welding strips may be arranged and welded on a back surface of the solar cells, or the welding strips may be arranged and welded on both the back surface and the front surface of the solar cells. Those skilled in the art may arrange the welding strips as required.

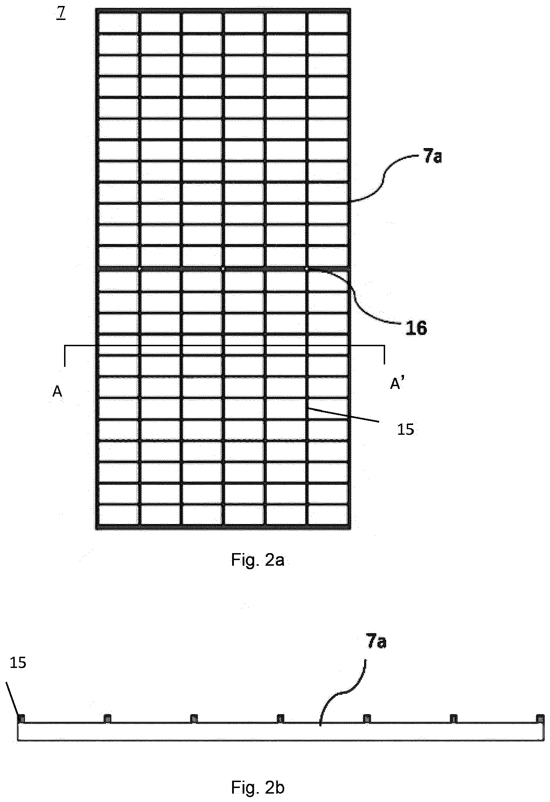

According to present invention, fabricating a back plate, wherein a reserved hole is opened in the back plate, includes: providing a back plate glass, and form the reserved hole in the back plate glass; and printing the glass glaze in a periphery and a portion of a middle region of the back plate glass by using a template, wherein, the reserved hole is also configured to lead out a lead of the solar cell string. By arranging the glass glaze in the portion of the middle region of the back plate material, after curing, the glass glaze can act as a reflective material, which can reflect sunlight incident thereon back to the solar cells, thereby further improving a light conversion rate. FIG. 2a shows a plan view of a back plate. In a back plate 7, a reserved hole 16 is opened in a back plate glass 7a, and a glass glaze 15 is formed in a grid shape and dispersed in a periphery and a middle of the back plate glass 7a. FIG. 2b is a cross-sectional view of the back plate taken along line A-A' in FIG. 2a; the glass glaze 15 is arranged in the periphery and the portion of the middle region of the back plate glass 7a; here, the cross-sectional view of the back plate glass is not taken at the reserved hole 16, but the reserved hole penetrates the entire back plate glass.

For example, forming a reserved hole in the back plate glass may be done by drilling a hole, and the reserved hole may be located at an edge of the solar cell module, which facilitates leading out the lead for electrical connection.

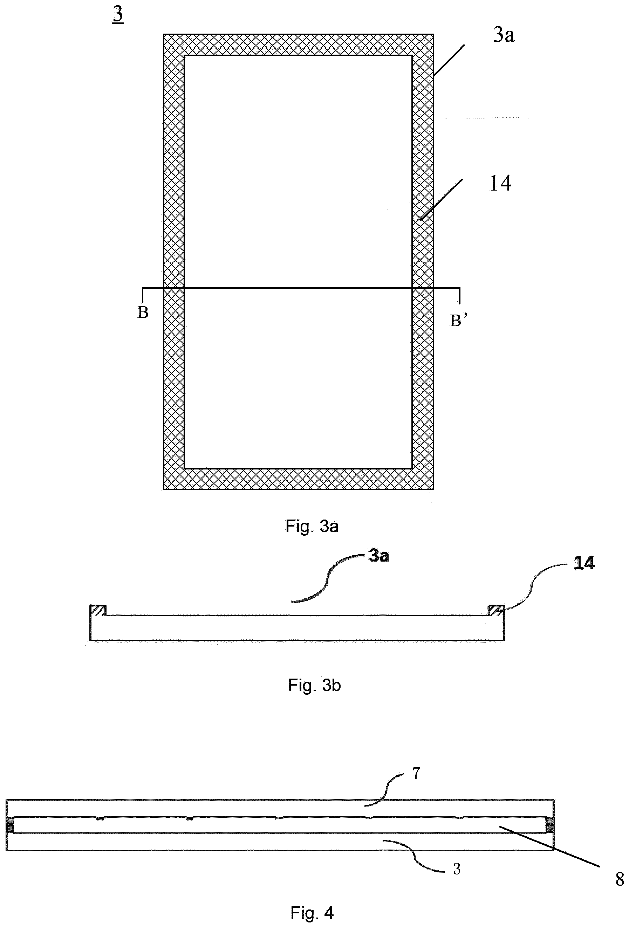

For example, in one example, providing a front plate may include: providing a front plate glass; and printing the glass glaze in a periphery of the front plate glass by using a template. FIG. 3a shows a plan view of a front plate. In a front plate 3, a glass glaze 14 is formed in a periphery of a front plate glass 3a. FIG. 3b shows a cross-sectional view of the front plate taken along line B-B' in FIG. 3a.

For example, in FIGS. 2b and 3b, the glass glaze is shown as a continuous strip, but the form of the glass glaze is not limited. For example, the glass glaze may be arranged as segmented strips in the portion of the middle region, which is not limited in this embodiment, and the glass glaze may be arranged according to bonding requirements.

For example, after arranging the solar cell string on the front plate, and before injecting an encapsulant material, the manufacturing method may further include: arranging the back plate on the solar cell string, to sandwich the solar cell string between the front plate and the back plate; and the injecting an encapsulant material, includes: injecting the encapsulant material through the reserved hole.

For example, after injecting an encapsulant material, and before curing the encapsulant material, the manufacturing method of a solar cell module according to this embodiment further includes: arranging the back plate on the solar cell string on which the encapsulant material is arranged, to sandwich the solar cell string and the encapsulant material between the front plate and the back plate; and the injecting the encapsulant material, includes: directly injecting the packing material between the solar cell string and the front plate glass and on the solar cell string.

For example, in one example, the arranging the solar cell string on the front plate, includes: transporting the solar cell string to the front plate using a manipulator; the arranging the back plate on the solar cell string, to sandwich the solar cell string between the front plate and the back plate, includes: arranging the back plate on one side of the solar cell string opposite to the front plate; leading out the lead of the solar cell string through the reserved hole; and aligning the glass glaze of the front plate with a glass glaze of the back plate, and aligning and fixing the back plate, the front plate, and the solar cell string; applying pressure to the back plate; curing the glass glazes of the front plate and back plate. Here, the solar cell string may include multiple rows and columns of solar cells, and connected solar cells are arranged on the front plate. As long as a position shift of the front plate, the back plate and the solar cell string can be prevented, the pressure applied when curing is enough, which is much smaller than the pressure during the lamination process of the encapsulant film in a conventional process, so it will not cause defects such as a hidden crack of the solar cell or a breakage of the welding strip. FIG. 4 shows a schematic diagram of a solar cell string 8 arranged between the front plate 3 and the back plate 7. For simplicity of illustration, the welding strips on the solar cell string are not shown in the drawing, but it should be clear to those skilled in the art that welding strips may be arranged on a front surface and/or a back surface of the solar cell string 8. As can be seen from the drawing, in a periphery of the solar cell, the glass glazes on the front plate 3 and the back plate 7 are bonded together.

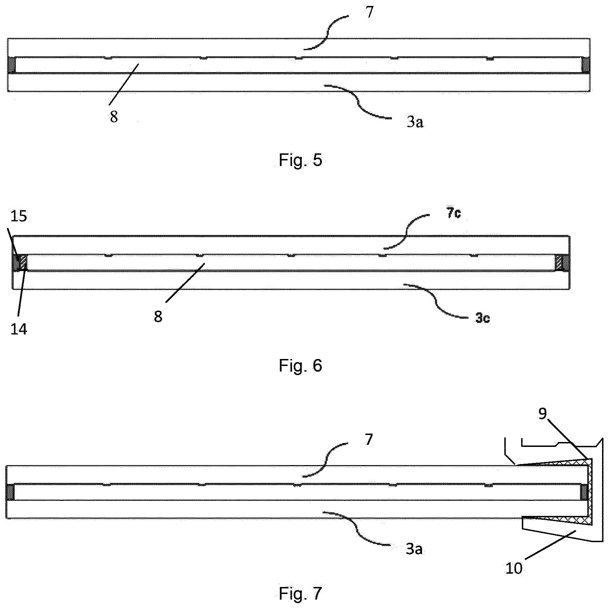

For example, in one example, a glass glaze may not be provided on the front plate glass, and providing a solar cell string may include: connecting a plurality of solar cells; welding a plurality of welding strips on at least one surface of the plurality of solar cells, to form a plurality of strings of solar cells; the providing a front plate may include: providing a front plate glass. The arranging the solar cell string on the front plate includes: arranging the plurality of strings of solar cells on the front plate glass; connecting the plurality of strings of solar cells in series or in parallel; and testing the plurality of strings of solar cells electrically connected, for example, performing an EL test. After arranging the solar cell string on the front plate, and before injecting an encapsulant material, the manufacturing method further includes: arranging the back plate on the solar cell string, to sandwich the solar cell string between the front plate and the back plate, which includes: arranging the back plate on one side of the solar cell string opposite to the front plate glass; leading out the lead of the solar cell string through the reserved hole; and aligning and fixing the back plate, the front plate glass, and the solar cell string; applying pressure to the back plate; curing the glass glaze of the back plate. The injecting an encapsulant material includes: injecting the encapsulant material through the reserved hole. FIG. 5 shows a schematic diagram of the solar cell string 8 arranged between the front glass 3a and the back plate 7. For simplicity of illustration, it can be seen from the drawing that in the periphery of the solar cell string, the glass glaze on the back plate 7 extends to the front plate glass 3a, to bond the front plate glass, the back plate and the solar cell string.

Or, it may also be: arranging the plurality of strings of solar cells on the front plate glass; connecting the plurality of strings of solar cells in series or in parallel; and after testing the plurality of strings of solar cells electrically connected, for example, performing an EL test, directly injecting the packing material into the solar cell string, and then applying the back plate, and curing the encapsulant material, which is not limited by the embodiments of the present disclosure.

For example, in one example, a thickness of the glass glaze on the back plate glass is 500 to 800 microns.

For example, in one example, a thickness of the glass glaze on the front plate glass is 40 to 60 microns.

For example, the glass glaze may be a low-temperature glass glaze, which can be cured at a low temperature without sintering, and may be applied on a glass surface of the finished front plate or finished back plate of a solar cell module. The glass glaze may include titanium dioxide, silicon dioxide, an adhesive and a solvent. The adhesive may include one or more of epoxy resin, acrylic resin and silicone.

For example, as shown in FIG. 6, fabricating a back plate, wherein a reserved hole is opened in the back plate, may further include: curing the glass glaze on the back plate glass, to obtain a back plate 7c; the providing a front plate, may further include: curing the glass glaze on the front plate, to obtain the front plate 3c; the arranging the back plate on the solar cell string on which the encapsulant material is arranged, may include: arranging the back plate on one side of the solar cell string opposite to the front plate glass; and leading out the lead of the solar cell string through the reserved hole.

For example, in this example, before the solar cell string is sandwiched between the front plate and the back plate, the glass glazes on the back plate and the front plate are cured, where the glass glaze may be a conventional glass glaze. The glass glaze may include titanium dioxide and silicon dioxide, and the silicon dioxide acts as an adhesive during high-temperature sintering. The glass glaze on the front plate glass is located in the periphery of the front plate glass and has a thickness of 500 to 800 microns, the glass glaze on the back plate glass is located in the periphery and the portion of the middle region of the back plate glass, a thickness of the glass glaze in the periphery of the back plate glass is less than or equal to the thickness of the glass glaze in the periphery of the front plate glass, and a thickness of the glass glaze in the middle portion region of the back plate glass is 40 to 60 microns. An orthogonal projection of the glass glaze on the front plate glass on the solar cell string may be located outside an orthogonal projection of the glass glaze on the back plate glass. FIG. 6 shows a schematic diagram of the solar cell string 8 arranged between the front plate 3c and the back plate 7c. For simplicity of illustration, it can be seen from the drawing that in the periphery of the solar cell, the glass glaze on the front plate glass 3a of the front plate 3c is located inside the glass glaze on the back plate 7c. The glass grit in the periphery of the front plate glass is high in thickness, so it can directly carry the encapsulant material. The glass glaze of the back plate overlaps with the glass glaze of the front plate, and then the glass glaze of the back plate is inside the glass glaze of the front plate. There is an extrusion process in the module manufacturing process, which facilitates contact between the encapsulant material and the back plate glass. Excessive encapsulant material can overflow from the hole in the middle and from the periphery to discharge all the gas, thereby improving an encapsulant effect of the encapsulant material on the solar cell module.

For example, an orthogonal projection of the glass glaze on the front plate glass on the solar cell string may be located outside an orthogonal projection of the glass glaze on the back plate glass, as long as the two are staggered and can be seamlessly connected after sandwiching the solar cell string, which is not limited in the embodiments of the present disclosure.

For example, in one example, the curing the encapsulant material, to obtain the solar cell module, may include: irradiating with ultraviolet light to cure the encapsulant material; or curing the encapsulant material at high temperature.

For example, in one example, after curing the encapsulant material, the manufacturing method of a solar cell module may further include: applying a sealant 9; and installing a frame 10 to form the solar cell module.

For example, further, before applying the sealant, the manufacturing method may further include: applying a sealing material and a desiccant between the front plate and the back plate, and arranging a sealant on an outer side of the back plate material and the front plate material on which the desiccant is applied, so as to implement a double-layer sealed solar cell module. The desiccant is added between the double-layer sealed, which can further prevent water vapor from infiltrating from around the module to damage the solar cell module, and improve the stability and performance of the solar cell module.

For example, the encapsulant material may be liquid silicone, and may also include one or more of ethylene-vinyl acetate copolymer (EVA), polyolefin elastomer (POE) and polyvinyl butyral (PVB). For example, the encapsulant material may be ethylene-vinyl acetate copolymer (EVA), polyolefin elastomer (POE) or polyvinyl butyral (PVB), or may be a mixture of any two of the three or a mixture of the three.

For example, the polyolefin elastomer may be one or more of copolymers of ethylene and butene, pentene, hexene or octene. When the encapsulant material is ethylene-vinyl acetate copolymer (EVA), EVA materials with different vinyl acetate (VA) contents may be used. When the encapsulant material is polyolefin elastomer, copolymers of ethylene and butene, pentene, hexene or octene or copolymers of ethylene and butene, pentene, hexene or octene with different ethylene contents, a mixture of two of EVA, POE and PVB with different corresponding contents, or a mixture of the three with different contents, may be used. When the encapsulant material film includes encapsulant materials with the same component or composition but with different contents, they may be regarded as different encapsulant materials. For example, when the encapsulant material is ethylene-vinyl acetate copolymer, when the components are the same but the VA content is different, it may be considered as a different encapsulant material. When the encapsulant material is a mixture of polymer materials, when the composition is the same but the content is different, for example, when the encapsulant material includes a mixture of EVA and POE, if the content of EVA is different, it may be considered as a different encapsulant material. Only these two examples are given, and those skilled in the art may deduce other cases, so details will not be described here.

An embodiment of the present invention not falling under the scope of protection further provides a solar cell module, which is manufactured by any of the manufacturing methods described above.

Hereinafter, several examples of the manufacturing method of the solar cell module according to the embodiments of the present disclosure are given with reference to the accompanying drawings.

Example 1: an exemplary manufacturing method of a solar cell module is as follows:
The module manufacturing process described in the example is as follows:
(1) Fabricating a solar cell string according to a design, and inspecting and testing;
(2) Carrying out positioning and arranging according to a circuit design; welding in series and in parallel using busbars, to form a circuit portion of the module, that is, the solar cell string electrically connected; and performing EL detection, to ensure the solar cell and the circuit have no problems;
(3) Fabricating the front plate material glass 3a, and printing the glass glaze 14 on the front plate material glass 3a using a template, a thickness of the glass glaze being 500 to 800 micros, as shown in FIGS. 3a and 3b;
(4) Fabricating the back plate glass 7a, and printing the glass glaze 15 on the back plate glass 7a using a template, a thickness of the glass glaze being 50 microns, as shown in FIGS. 2a and 2b;
(5) Moving the whole circuit portion of the module to the front plate 3 using a manipulator, then covering the back plate 7, and leading out a lead in the circuit portion of the module through the reserved hole 16 of the back plate 7, to obtain a structure as shown in FIG. 4;
(6) Aligning and fixing the periphery of the module, applying pressure above the back plate, then partially scanning the periphery of the module using a laser to cure the glass glazes, to ensure that the glass glazes on the front surface and the back surface are completely cured, and the front plate and the back plate are bonded together;
(7) Injecting liquid silicone through the reserved hole 16 in the back plate to ensure that the liquid silicone completely covers the solar cell string without any wires or solar cells exposed;
(8) Irradiating the sealed portion of the module with ultraviolet light and applying a small amount of vacuum to ensure that air bubbles are discharged to complete a curing operation; and
(9) Applying the sealant 9, and installing the frame 10, and carrying out other subsequent steps to form the solar cell module.

Wherein, the glass glaze 14 is applied in the periphery of the front plate material glass 3a, and the glass glaze 15 is also applied in the periphery and the portion of the middle region of the back plate glass 7a. The glass glaze is a low-temperature glass glaze, which has a high reflection characteristic and contains titanium dioxide, silicon dioxide, an adhesive, and a solvent, etc. The adhesive is one or more of epoxy resin, acrylic resin or silicone. The glass glaze in this embodiment is cured at a low temperature without sintering, and can be applied on a glass surface of the finished photovoltaic front plate or back plate. Before applying, it needs to make sure the glass surface is clean to ensure adhesion of the glass glaze to the glass. The encapsulant material is liquid silicone, which has high transmittance and may be cured at a high temperature or may be light cured.

Example 2: an exemplary manufacturing method of a solar cell module is as follows:
The module manufacturing process described in this example is as follows:
(1) Fabricating a solar cell string according to a design, and inspecting and testing;
(2) Laying the front plate material glass 3a, carrying out positioning and arranging on the front plate material glass 3a according to a circuit design; welding in series and in parallel using busbars, to form a circuit portion of the module; and performing EL detection, to ensure the battery and the circuit have no problems;
(3) Fabricating the back plate glass 7a, and printing the glass glaze 14 on the back plate glass 7a using a template, to form the back plate 7, wherein, a height of the glass glaze in the periphery of the glass is 500 to 800 microns, and a height of the glass grit in other regions of the glass is 50 microns;
(4) Covering the back plate 7, and leading out a lead in the circuit portion of the module through the reserved hole 16 of the back plate 7, to obtain a structure as shown in FIG. 5;
(5) Fixing the periphery of the module by using a tool, applying pressure above the back plate glass, then partially scanning using a laser to cure the glass glazes, to ensure that the glass glazes on the front surface and the back surface are completely cured, and the front plate and the back plate are bonded together;
(6) Injecting liquid silicone through the reserved hole 16 in the back plate to ensure that the liquid silicone completely covers the solar cell string without any wires or solar cells exposed;
(7) Irradiating the sealed portion of the module with ultraviolet light and applying a small amount of vacuum to ensure that air bubbles are discharged to complete a curing operation; and
(8) Applying the sealant 9, and installing the frame 10, and carrying out other subsequent steps to form the solar cell module.

Wherein, the glass glaze 15 is applied in the periphery of the back plate glass 7a. The glass glaze 15 is a low-temperature glass glaze, which has a high reflection characteristic and contains titanium dioxide, silicon dioxide, an adhesive, and a solvent, etc. The adhesive is one or more of epoxy resin, acrylic resin or silicone. The glass glaze in this embodiment is cured at a low temperature without sintering, and may be applied on a glass surface of the finished photovoltaic front plate or back plate. Before applying, it needs to make sure the glass surface is clean to ensure adhesion of the glass glaze to the glass. Wherein, the glass glaze in the periphery of the glass has two functions of reflection and sealing, and its height is greater than that of the glass grit in the periphery of the solar cell in the middle. The encapsulant material is liquid silicone, which has high transmittance and may be cured at a high temperature or may be light cured.

Example 3: an exemplary manufacturing method of a solar cell module is as follows:
The module manufacturing process described in this example is as follows:
(1) Fabricating the front plate material glass 3a, printing the glass glaze 14 on the front plate material glass 3a using a template, and sintering and curing to form the front plate 3c, as shown in FIG. 6;
(2) Fabricating the back plate glass 7a, printing the glass glaze 15 on the back plate glass 7a using a template, and sintering and curing to form the back plate 7c, as shown in FIG. 6;
(3) Fabricating a solar cell string according to a design, and inspecting and testing;
(4) Laying the front plate 3c, carrying out positioning and arranging on the front plate 3c according to a circuit design; welding in series and in parallel using busbars, to form a circuit portion of the module; and performing EL detection, to ensure the battery and the circuit have no problems;
(5) Injecting liquid silicone in the front plate 3c, to ensure that the liquid silicone completely covers the solar cell string without any wires or solar cells exposed;
(6) Covering the back plate 7c, and leading out a lead in the circuit portion of the module through the reserved hole 16 of the back plate 7c;
(7) Injecting supplementarily the liquid silicone through a lead-out hole 16 of the back plate glass to ensure discharge of air bubbles;
(8) Irradiating the sealed portion of the module with ultraviolet light and applying a small amount of vacuum to ensure that air bubbles are discharged to complete a curing operation; and
(9) Applying the sealant 9, and installing the frame 10, and carrying out other subsequent steps to form the solar cell module.

The glass glaze 14 is applied in the periphery of the front plate material glass 3a, and the glass glaze 15 is also applied in the periphery of the back plate glass 7a. The glass glaze is a conventional glass glaze that may be sintered at a high temperature, also has high reflectivity, needs to be printed on the glass surface when making the glass, and sintered during tempering to firmly adhere to the glass surface. The surfaces of both the front plate 3c and the back plate 7c are applied with the glass glaze and have been sintered when the module is assembled. The glass glaze of the front plate material glass 3a is applied in the periphery of the glass, and has a thickness of 500 to 800 microns; a thickness of the glass glaze in the periphery of the back plate glass 7a is less than or equal to the thickness of the glass glaze in the periphery of the front plate glass 3a, a thickness of the glass glaze in the middle region of the back plate glass 7a is about 50 microns, and a length and a width of the glaze of the front plate glass 3a are slightly greater than an inner diameter of the glaze of the back plate glass 7a. The glass grit in the periphery of the front plate glass is high in thickness, so it can directly carry the encapsulant material. The glaze of the back plate glass overlaps with the glaze of the front plate glass, and then the glaze of the back plate glass is inside the glaze of the front plate glass. There is an extrusion process in the module manufacturing process, which facilitates contact between the encapsulant material and the back plate glass. Excessive encapsulant material can overflow from the hole in the middle and from the periphery to discharge all the gas. The encapsulant material is liquid silicone, which has high transmittance and may be cured at a high temperature or may be light cured.

The solar cell module and manufacturing method thereof provided by the embodiments of the present disclosure have the following beneficial effects:
1. The encapsulant material is directly injected or is injected through an injection hole without a lamination process, which avoids the pressure exerted by the lamination process on the solar cell string, and thus prevents the solar cell string from defects such as hidden cracks and fractures caused by pressure, and avoids breakage of the welding strip due to pressure, etc.;
2. Since fluidity of the liquid encapsulant material is very good, the gap can be well filled. As compared with the conventional process that needs to laminate the encapsulant material, it can reduce the total amount of the encapsulant material used, and reduce the distance between the back plate material and the solar cell string and/or the distance between the front plate material and the solar cell string;
3. The front plate with the glass glaze applied in the middle portion region is adopted, so that after the solar cell string is sandwiched between the front plate and the back plate to form the solar cell module, the glass glaze in the middle portion region can also reflect sunlight incident thereon to improve the energy conversion efficiency of the solar cell module;
4. The encapsulant material is applied in the subsequent process, the gap can be well filled by the material to fully protect the welding strip, and better bond the back plate material and the solar cell;
5. Double-layer sealing is used for the solar cell module, and a desiccant is added between the double-layer sealing, thereby further preventing water vapor from infiltrating from around the module to damage the solar cell module, and improving the stability and performance of the solar cell module.

## Claims

1. A manufacturing method of a solar cell module, comprising:
providing a solar cell string (8);
fabricating a back plate (7), a reserved hole (16) being opened in the back plate (7);
providing a front plate (3);
arranging the solar cell string (8) on the front plate (3);
injecting an encapsulant material; and
curing the encapsulant material, to obtain the solar cell module,
wherein the fabricating a back plate (7), a reserved hole (16) being opened in the back plate (7), comprises:
providing a back plate glass (7a), and forming the reserved hole (16) in the back plate glass (7a); and
printing glass glaze (15) in a periphery and a portion of a middle region of the back plate glass (7a) using a template,
wherein the reserved hole (16) is also configured to lead out a lead of the solar cell string (8),
wherein the providing the front plate (3) comprises:
providing a front plate glass (3a); and
printing glass glaze (14) in a periphery of the front plate glass (3a) by using a template,
wherein:
2
the providing a solar cell string (8) comprises:
connecting a plurality of solar cells;
welding a plurality of welding strips on at least one surface of the plurality of solar cells, to form a plurality of strings of solar cells;
wherein the arranging the solar cell string (8) on the front plate (3), comprises
arranging the plurality of strings of solar cells on the front plate glass (3a);
connecting the plurality of strings of solar cells in series or in parallel; and
testing the plurality of strings of solar cells electrically connected; after arranging the solar cell string (8) on the front plate (3), the manufacturing method further comprises:
arranging the back plate (7) on the solar cell string (8), to sandwich the solar cell string (8) between the front plate (3) and the back plate (7), comprising:
arranging the back plate (7) on a side of the solar cell string (8) opposite to the front plate glass (3a);
leading out the lead of the solar cell string (8) through the reserved hole (16); and
aligning and fixing the back plate (7), the front plate glass (3a), and the solar cell string (8);
applying pressure to the back plate (7);
curing the glass glaze (15) of the back plate (7);
wherein the injecting an encapsulant material, comprises:
injecting the encapsulant material through the reserved hole (16) after the step of arranging the back plate (7); or directly injecting the packing material between the solar cell string (8) and the front plate glass (3a) and on the solar cell string (8) followed by the step of arranging the back plate (7) before curing of the encapsulant material.

2. The manufacturing method according to claim 1, wherein the arranging the solar cell string (8) on the front plate (3), comprises:
transporting the solar cell string (8) to the front plate (3) using a manipulator;
the arranging the back plate (7) on the solar cell string (8), to sandwich the solar cell string (8) between the front plate (3) and the back plate (7), comprises:
arranging the back plate (7) on a side of the solar cell string (8) opposite to the front plate (3);
leading out the lead of the solar cell string (8) through the reserved hole (16); and
aligning the glass glaze (14) of the front plate (3) with the glass glaze (15) of the back plate (7), and aligning and fixing the back plate (7), the front plate (3), and the solar cell string (8);
applying pressure to the back plate (7);
curing the glass glazes (14,15) of the front plate (3) and back plate (7).

3. The manufacturing method according to claim 1, wherein the curing the encapsulant material, to obtain the solar cell module, comprises:
irradiating with ultraviolet light to cure the encapsulant material,
wherein after curing the encapsulant material, the manufacturing method further comprises:
applying a sealant (9); and
installing a frame (10), to form the solar cell module.

4. The manufacturing method according to claim 1, wherein a thickness of the glass glaze (15) on the back plate glass (7a) is 500 to 800 microns, a thickness of the glass glaze (14) on the front plate glass (3a) is 40 to 60 microns.

5. The manufacturing method according to claim 2, wherein the glass glaze (14,15) is a low-temperature glass glaze comprising titanium dioxide, silicon dioxide, an adhesive and a solvent, the adhesive comprises one or more of epoxy resin, acrylic resin and silicone, .

6. The manufacturing method according to claim 1, wherein the glass glaze (14,15) is a conventional glass glaze.

7. The manufacturing method according to claim 6, wherein the glass glaze (14) on the front plate glass (3a) is located in a periphery of the front plate glass (3a) and has a thickness of 500 to 800 microns, the glass glaze (15) on the back plate glass (7a) is located in a periphery and a portion of a middle region of the back plate glass (7a), a thickness of the glass glaze in the periphery of the back plate glass (7a) is less than or equal to the thickness of the glass glaze (14) on the front plate glass (3a), and a thickness of the glass glaze (15) in the portions of the middle region of the back plate glass (7a) is 40 to 60 microns.

8. The manufacturing method according to claim 7, wherein an orthogonal projection of the glass glaze (15) on the back plate glass (7a) is located inside an orthogonal projection of the glass glaze (14) on the front plate glass (3a).

## Patentansprüche

1. Ein Herstellungsverfahren für ein Solarzellenmodul, umfassend:
Bereitstellen einer Solarzellenkette (8);
Herstellen einer Rückplatte (7), wobei ein reserviertes Loch (16) in der Rückplatte (7) geöffnet wird;
Bereitstellen einer Frontplatte (3);
Anordnen der Solarzellenkette (8) auf der Frontplatte (3);
Einspritzen eines Einkapselungsmaterials; und
Aushärten des Einkapselungsmaterials, um das Solarzellenmodul zu erhalten,
wobei das Herstellen einer Rückplatte (7), wobei ein reserviertes Loch (16) geöffnet wird, umfasst:
Bereitstellen eines Rückplattenglases (7a) und Formen des reservierten Lochs (16) im Rückplattenglas (7a); und
Drucken einer Glasbeschichtung (15) im Randbereich und in einem Teil des mittleren Bereichs des Rückplattenglases (7a) mittels einer Schablone,
wobei das reservierte Loch (16) auch so konfiguriert ist, dass es eine Leitung der Solarzellenkette (8) hinausführt,
wobei das Bereitstellen der Frontplatte (3) umfasst:
Bereitstellen eines Frontplattenglases (3a); und
Drucken einer Glasbeschichtung (14) im Randbereich des Frontplattenglases (3a) mittels einer Schablone,
wobei:
das Bereitstellen einer Solarzellenkette (8) umfasst:
Verbinden einer Vielzahl von Solarzellen;
Verschweißen einer Vielzahl von Schweißstreifen auf mindestens einer Oberfläche der Vielzahl von Solarzellen, um eine Vielzahl von Solarzellenketten zu bilden;
das Anordnen der Solarzellenkette (8) auf der Frontplatte (3) umfasst:
Anordnen der Vielzahl von Solarzellenketten auf dem Frontplattenglas (3a);
Verbinden der Vielzahl von Solarzellenketten in Reihe oder parallel; und
Testen der Vielzahl der elektrisch verbundenen Solarzellenketten;
nach dem Anordnen der Solarzellenkette (8) auf der Frontplatte (3) umfasst das Herstellungsverfahren weiterhin:
Anordnen der Rückplatte (7) auf der Solarzellenkette (8), sodass die Solarzellenkette (8) zwischen der Frontplatte (3) und der Rückplatte (7) eingelegt wird, wobei dies umfasst:
Anordnen der Rückplatte (7) auf einer Seite der Solarzellenkette (8), die der Frontplattenglas (3a) gegenüberliegt;
Hinausführen der Leitung der Solarzellenkette (8) durch das reservierte Loch (16); und
Ausrichten und Fixieren der Rückplatte (7), des Frontplattenglases (3a) und der Solarzellenkette (8);
Ausüben von Druck auf die Rückplatte (7);
Aushärten der Glasbeschichtung (15) der Rückplatte (7);
wobei das Einspritzen eines Einkapselungsmaterials umfasst:
Einspritzen des Einkapselungsmaterials durch das reservierte Loch (16) nach dem Schritt des Anordnens der Rückplatte (7); oder
direktes Einspritzen des Verpackungsmaterials zwischen die Solarzellenkette (8) und das Frontplattenglas (3a) und auf die Solarzellenkette (8), gefolgt vom Schritt des Anordnens der Rückplatte (7) vor dem Aushärten des Einkapselungsmaterials.

2. Das Herstellungsverfahren gemäß Anspruch 1, wobei das Anordnen der Solarzellenkette (8) auf der Frontplatte (3) umfasst:
Transportieren der Solarzellenkette (8) zur Frontplatte (3) mit einem Manipulator;
das Anordnen der Rückplatte (7) auf der Solarzellenkette (8), um die Solarzellenkette (8) zwischen der Frontplatte (3) und der Rückplatte (7) einzuschließen, umfasst:
Anordnen der Rückplatte (7) auf einer Seite der Solarzellenkette (8), die der Frontplatte (3) gegenüberliegt;
Hinausführen der Leitung der Solarzellenkette (8) durch das reservierte Loch (16); und
Ausrichten der Glasbeschichtung (14) der Frontplatte (3) mit der Glasbeschichtung (15) der Rückplatte (7) sowie Ausrichten und Fixieren der Rückplatte (7), der Frontplatte (3) und der Solarzellenkette (8);
Ausüben von Druck auf die Rückplatte (7);
Aushärten der Glasbeschichtungen (14, 15) der Frontplatte (3) und Rückplatte (7).

3. Das Herstellungsverfahren gemäß Anspruch 1, wobei das Aushärten des Einkapselungsmaterials, um das Solarzellenmodul zu erhalten, umfasst:
Bestrahlen mit ultraviolettem Licht, um das Einkapselungsmaterial auszuhärten,
wobei nach dem Aushärten des Einkapselungsmaterials das Herstellungsverfahren weiterhin umfasst:
Aufbringen eines Dichtmittels (9); und
Installieren eines Rahmens (10), um das Solarzellenmodul zu bilden.

4. Das Herstellungsverfahren gemäß Anspruch 1, wobei die Dicke der Glasbeschichtung (15) auf dem Rückplattenglas (7a) zwischen 500 und 800 Mikrometer liegt und die Dicke der Glasbeschichtung (14) auf dem Frontplattenglas (3a) zwischen 40 und 60 Mikrometer liegt.

5. Das Herstellungsverfahren gemäß Anspruch 2, wobei die Glasbeschichtung (14, 15) eine Niedertemperatur-Glasbeschichtung ist, die Titandioxid, Siliziumdioxid, ein Klebstoff und ein Lösungsmittel umfasst, wobei der Klebstoff eine oder mehrere von Epoxidharz, Acrylharz und Silikon umfasst.

6. Das Herstellungsverfahren gemäß Anspruch 1, wobei die Glasbeschichtung (14, 15) eine herkömmliche Glasbeschichtung ist.

7. Das Herstellungsverfahren gemäß Anspruch 6, wobei die Glasbeschichtung (14) auf dem Frontplattenglas (3a) sich im Randbereich des Frontplattenglases (3a) befindet und eine Dicke von 500 bis 800 Mikrometer aufweist, die Glasbeschichtung (15) auf dem Rückplattenglas (7a) sich im Randbereich und in einem Teil des mittleren Bereichs des Rückplattenglases (7a) befindet, die Dicke der Glasbeschichtung im Randbereich des Rückplattenglases (7a) kleiner oder gleich der Dicke der Glasbeschichtung (14) auf dem Frontplattenglas (3a) ist und die Dicke der Glasbeschichtung (15) in den Teilen des mittleren Bereichs des Rückplattenglases (7a) zwischen 40 und 60 Mikrometer beträgt.

8. Das Herstellungsverfahren gemäß Anspruch 7, wobei eine orthogonale Projektion der Glasbeschichtung (15) auf dem Rückplattenglas (7a) sich innerhalb einer orthogonalen Projektion der Glasbeschichtung (14) auf dem Frontplattenglas (3a) befindet.

## Revendications

1. Un procédé de fabrication d'un module de cellules solaires, comprenant :
fournir une chaîne de cellules solaires (8) ;
fabriquer une plaque arrière (7), un trou réservé (16) étant ouvert dans la plaque arrière (7) ;
fournir une plaque avant (3) ;
disposer la chaîne de cellules solaires (8) sur la plaque avant (3) ;
injecter un matériau d'encapsulation ; et
durcir le matériau d'encapsulation pour obtenir le module de cellules solaires,
dans lequel la fabrication de la plaque arrière (7), un trou réservé (16) étant ouvert dans la plaque arrière (7), comprend :
fournir un verre de plaque arrière (7a) et former le trou réservé (16) dans le verre de plaque arrière (7a) ; et
imprimer une glaçure de verre (15) sur le périmètre et une partie de la région centrale du verre de plaque arrière (7a) à l'aide d'un modèle,
dans lequel le trou réservé (16) est également configuré pour faire sortir un fil conducteur de la chaîne de cellules solaires (8),
dans lequel la fourniture de la plaque avant (3) comprend :
fournir un verre de plaque avant (3a) ; et
imprimer une glaçure de verre (14) sur le périmètre du verre de plaque avant (3a) à l'aide d'un modèle,
dans lequel :
la fourniture d'une chaîne de cellules solaires (8) comprend :
connecter une pluralité de cellules solaires ;
souder une pluralité de bandes de soudure sur au moins une surface des cellules solaires pour former une pluralité de chaînes de cellules solaires ;
dans lequel la disposition de la chaîne de cellules solaires (8) sur la plaque avant (3) comprend :
disposer la pluralité de chaînes de cellules solaires sur le verre de plaque avant (3a) ;
connecter la pluralité de chaînes de cellules solaires en série ou en parallèle ; et
tester la pluralité des chaînes de cellules solaires électriquement connectées ;
après avoir disposé la chaîne de cellules solaires (8) sur la plaque avant (3), le procédé de fabrication comprend en outre :
disposer la plaque arrière (7) sur la chaîne de cellules solaires (8), de manière à insérer la chaîne de cellules solaires (8) entre la plaque avant (3) et la plaque arrière (7), ce qui comprend :
disposer la plaque arrière (7) sur une face de la chaîne de cellules solaires (8) opposée au verre de plaque avant (3a) ;
faire sortir le fil conducteur de la chaîne de cellules solaires (8) par le trou réservé (16) ; et
aligner et fixer la plaque arrière (7), le verre de plaque avant (3a) et la chaîne de cellules solaires (8) ;
appliquer une pression sur la plaque arrière (7) ;
et durcir la glaçure de verre (15) de la plaque arrière (7) ;
dans lequel l'injection d'un matériau d'encapsulation comprend :
injecter le matériau d'encapsulation par le trou réservé (16) après l'étape de disposition de la plaque arrière (7) ; ou
injecter directement le matériau d'emballage entre la chaîne de cellules solaires (8) et le verre de plaque avant (3a) et sur la chaîne de cellules solaires (8), suivi par l'étape de disposition de la plaque arrière (7) avant le durcissement du matériau d'encapsulation.

2. Le procédé de fabrication selon la revendication 1, dans lequel la disposition de la chaîne de cellules solaires (8) sur la plaque avant (3) comprend :
transporter la chaîne de cellules solaires (8) vers la plaque avant (3) à l'aide d'un manipulateur ;
la disposition de la plaque arrière (7) sur la chaîne de cellules solaires (8), pour insérer la chaîne de cellules solaires (8) entre la plaque avant (3) et la plaque arrière (7), comprend :
disposer la plaque arrière (7) sur une face de la chaîne de cellules solaires (8) opposée à la plaque avant (3) ;
faire sortir le fil conducteur de la chaîne de cellules solaires (8) par le trou réservé (16) ; et
aligner la glaçure de verre (14) de la plaque avant (3) avec la glaçure de verre (15) de la plaque arrière (7), et aligner et fixer la plaque arrière (7), la plaque avant (3) et la chaîne de cellules solaires (8) ;
appliquer une pression sur la plaque arrière (7) ;
et durcir les glaçures de verre (14, 15) de la plaque avant (3) et de la plaque arrière (7).

3. Le procédé de fabrication selon la revendication 1, dans lequel le durcissement du matériau d'encapsulation, pour obtenir le module de cellules solaires, comprend :
irradier avec de la lumière ultraviolette pour durcir le matériau d'encapsulation,
dans lequel après le durcissement du matériau d'encapsulation, le procédé de fabrication comprend en outre :
appliquer un agent d'étanchéité (9) ; et
installer un cadre (10), pour former le module de cellules solaires.

4. Le procédé de fabrication selon la revendication 1, dans lequel l'épaisseur de la glaçure de verre (15) sur le verre de plaque arrière (7a) est comprise entre 500 et 800 microns, et l'épaisseur de la glaçure de verre (14) sur le verre de plaque avant (3a) est comprise entre 40 et 60 microns.

5. Le procédé de fabrication selon la revendication 2, dans lequel la glaçure de verre (14, 15) est une glaçure de verre à basse température comprenant du dioxyde de titane, du dioxyde de silicium, un adhésif et un solvant, l'adhésif comprenant un ou plusieurs des éléments suivants : résine époxy, résine acrylique et silicone.

6. Le procédé de fabrication selon la revendication 1, dans lequel la glaçure de verre (14, 15) est une glaçure de verre conventionnelle.

7. Le procédé de fabrication selon la revendication 6, dans lequel la glaçure de verre (14) sur le verre de plaque avant (3a) est située dans un périmètre du verre de plaque avant (3a) et a une épaisseur comprise entre 500 et 800 microns, la glaçure de verre (15) sur le verre de plaque arrière (7a) est située dans un périmètre et une partie de la région centrale du verre de plaque arrière (7a), une épaisseur de la glaçure de verre dans le périmètre du verre de plaque arrière (7a) est inférieure ou égale à l'épaisseur de la glaçure de verre (14) sur le verre de plaque avant (3a), et une épaisseur de la glaçure de verre (15) dans les parties de la région centrale du verre de plaque arrière (7a) est comprise entre 40 et 60 microns.

8. Le procédé de fabrication selon la revendication 7, dans lequel une projection orthogonale de la glaçure de verre (15) sur le verre de plaque arrière (7a) est située à l'intérieur d'une projection orthogonale de la glaçure de verre (14) sur le verre de plaque avant (3a).
